# EUROPEAN PATENT APPLICATION

(11) **EP 2 239 818 A1**
(43) Date of publication of application: **13.10.2010**
(21) Application number: 09706029.7
(22) Date of filing: 21.01.2009
(51) Int. Cl.: H01R 12/16, H01L 23/32, H01R 12/04

(54) **HOLDING MEMBER, MOUNTING STRUCTURE HAVING THE HOLDING MEMBER MOUNTED IN ELECTRIC CIRCUIT BOARD, AND ELECTRONIC PART HAVING THE HOLDING MEMBER**

(30) Priority: 30.01.2008 JP 2008019277
(71) Applicant: Tyco Electronics Japan G.K., Takatsu-ku Kawasaki-shi Kanagawa 213-8535 (JP)
(72) Inventor: HAYASHI, Toshiaki, Kawasaki-shi Kanagawa 2138535 (JP)
(74) Representative: Johnstone, Douglas Ian
(86) International application number: PCT/JP2009/050841
(87) International publication number: WO 2009/096282

(57) **Abstract**

It is an object to provide a holding member and the like that prevent leg sections from coming out of a through hole in a state in which the holding member is merely pushed into the through hole and yet to be soldered, without damaging a surface of an electric circuit board. A pair of leg sections 20 pushed into a through hole 51 have, at respective tips, respective claws 24a and 24b having slopes 25a and 25b, respectively. The slopes 25a and 25b extend in directions approaching each other and face in opposite directions while being inclined relative to a width direction of a base section 10. When the pair of leg sections 20 are pushed into the through hole 51 while contacting an inner surface of the through hole 51 at both ends in a longitudinal direction, the slopes 25a and 25b of the pair of leg sections 20 contact and press each other so that the claws 24a and 24b formed at the tips of the pair of leg sections 20 advance along the slopes 25a and 25b in a slanting direction, pass through the through hole 51, and protrude in a board thickness direction of the base section 10 beyond the through hole 51, thereby being caught on an edge of the through hole 51.

## Description

### Technical Field

The present invention relates to a holding member pushed into a through hole formed in an electric circuit board thereby holding an electronic part on the electric circuit board, a mounting structure having such a holding member mounted in an electric circuit board, and an electronic part having such a holding member.

### Background Art

Conventionally, as a technique for mounting an electronic part such as a connector on an electric circuit board, there is known, for example, a technique for holding an electronic part on an electric circuit board by pushing a holding member attached to the electronic part into a through hole formed in the electric circuit board. Further, there is a case in which the holding member is soldered to the electric circuit board in order to firmly fix the electronic part to the electric circuit board.

As such a holding member, there is proposed, for example, a holding member having: a pair of leg sections that extend in the approximately same direction from a tabular base section fixed to a connector, have respective wide-width spring pieces capable of being elastically displaced in a board thickness direction, and face each other; and a second leg section that is disposed between the pair of leg sections and extends in the same direction as the direction in which the pair of leg sections extend (see, for example, Patent literature 1). According to this holding member, molten solder streams along the second leg section thereby easily rising within the through hole in a solder flow process, and the strength of attachment of the connector to the electric circuit board after the soldering is high. When this holding member is pushed into the through hole, the pair of leg sections elastically deform in the board thickness direction. In a state in which the holding member is merely pushed into the through hole and yet to be soldered, the holding member is held not to fall off the electric circuit board by having the outer surfaces of the pair of leg sections being in contact with an inner surface of the through hole. Moreover, this holding member has such an advantage that the holding member does not damage the inner surface of the through hole when being inserted into (removed from) the through hole. However, this holding member has such a disadvantage that it is difficult to increase the elasticity (spring constant) of the leg sections. Therefore, this holding member has a low holding strength in the state in which the holding member is merely pushed into the through hole and yet to be soldered. For this reason, for example, when the connector is grasped and handled by a robot while the holding member is in such a state, or when the holding member in such a state is pulled hard, the leg sections of the holding member may come out of the through hole.
Patent Literature 1: Japanese Patent Laid-Open No. 2007-128772

### Disclosure of the Invention

In view of the foregoing circumstances, it is an object of the present invention to provide: a holding member that prevents a leg section from coming out of a through hole in a state of being merely pushed into through hole and yet to be soldered, without damaging a surface of an electric circuit board; a mounting structure in which such a holding member is mounted on an electric circuit board; and an electronic part having such a holding member.

According to the present invention, a holding member that holds an electronic part on an electric circuit board by being pushed into a through hole formed in the electric circuit board, includes:
a base section that has a plate-like shape and is fixed to the electronic part; and
a pair of leg sections that extend in directions approximately equal to each other and are pushed into the through hole while contacting an inner surface of the through hole,
wherein the pair of leg sections have, at respective tip portions, respective slopes that extend in directions approaching each other and facing in opposite directions while being inclined relative to a width direction of the base section, and when the pair of leg sections are pushed into the through hole while contacting the inner surface of the through hole, the respective slopes of the pair of leg sections contact and press each other so that a tip of at least one of the pair of leg sections advances in a slanting direction along the slop, and the tip of at least one of the pair of leg sections passes through the through hole and protrudes in a board thickness direction of the base section beyond the through hole so as to be caught on an edge of the through hole.

In the holding member of the present invention, the pair of leg sections pushed into the through hole respectively have slopes at the respective tip portions. These slopes extend in the directions approaching each other and face in opposite directions while being inclined relative to the width direction of the base section. Therefore, when the pair of leg sections are pushed into the through hole while contacting the inner surface of the through hole, the slopes contact and press each other and the tip of at least one of the pair of leg sections advances in the slanting direction along the slope. This tip of at least one of the pair of leg sections passes through the through hole and protrudes in the board thickness direction of the base section beyond the through hole, thereby being caught on the edge of the through hole. Thus, according to the holding member of the present invention, in the state in which the holding member is merely pushed into the through hole and yet to be soldered, the holding member is held on the electric circuit board by the tip of the leg section caught on the edge of the through hole, thereby preventing the pair of leg sections from coming out of the through hole, without damaging the surface of the electric circuit board.

Further, according to the holding member of the present invention, a wobble in the board thickness direction of the base section is suppressed by the tip of the leg section caught on the through hole. Furthermore, since the pair of leg sections are in contact with the inner surface of the through hole, a wobble in the width direction of the base section also is suppressed.

Moreover, according to the holding member of the present invention, the through hole is almost filled with the pair of leg sections being pushed in and thus, molten solder streams along the pair of leg sections and easily rises within the through hole in a solder flow process. In addition, since space in the though hole is filled with the solder, the strength of attachment after the soldering is higher than that of a conventional holding member.

Here, in the holding member, it is preferable that the pair of leg sections are symmetric, and when being pushed into the through hole, the respective tips of the pair of leg sections protrude in the board thickness direction of the base section beyond the through hole so as to be caught on the edge of the through hole.

According to such a preferable feature, in the state in which the holding member is merely pushed into the through hole and yet to be soldered, the holding member is retained not to fall off the electric circuit board because the respective tips of both of the leg sections are caught on the edge of the through hole.

In addition, it is preferable that the pair of leg sections have, at parts close to the base section, respective narrow-width sections that are formed to be narrow in width by being partially cut and plastically deform in response to distortion produced when the slopes advance in a slanting direction while contacting and pressing each other.

According to such a preferable feature, thanks to the plastic deformation of the narrow-width sections formed to be narrow in width by being partially cut, in the state in which the pair of leg sections are merely pushed into the through hole and yet to be soldered, the respective tips of the pair of leg sections are reliably caught on the edge of the through hole. Further, when the slopes advance in the slanting direction while contacting and pressing each other and the pair of leg sections are pushed into the through hole while contacting the inner surface of the through hole, a force received by the inner surface from the pair of leg sections is smaller than that in a case where such narrow-width sections are not provided and thus, the inner surface is not easily damaged.

Further, it is also preferable that "when the pair of leg sections are pushed into the through hole, the tip of only one of the pair of leg sections protrudes in the board thickness direction of the base section beyond the through hole thereby being caught on the edge of the through hole, and the one of the pair of leg sections has, at a part closer to the base section, a narrow-width section that is formed to be narrow in width by being partially cut and plastically deforms in response to distortion produced when the slopes advance in a slanting direction while contacting and pressing each other."

Such a preferable feature is effective in, for example, a case in which the through hole is formed near an edge portion of the electric circuit board and a housing also is close to the end portion so that only either one of the respective tips of the pair of leg sections may be made to protrude in the board thickness direction of the base section beyond the through hole. Further, according to such a preferable feature, thanks to the plastic deformation of the narrow-width section formed to be narrow in width by being partially cut, in the state in which the pair of leg sections are merely pushed into the through hole and yet to be soldered, the tip of one of the pair of leg section is reliably caught on the edge of the through hole. Furthermore, when the slopes advance in the slanting direction while contacting and pressing each other and the pair of leg sections are pushed into the through hole while contacting the inner surface of the through hole, a force received by the inner surface from the pair of leg sections is smaller than that in a case where such a narrow-width section is not provided and thus, the inner surface is not easily damaged.

Furthermore, it is preferable that the holding member is made of metal and has a surface to be wet with molten solder

According to such a preferable feature, the molten solder easily rises within the through hole in the solder flow process.

In addition, according to the preset invention, a mounting structure includes:
an electric circuit board that has a long through hole;
a holding member that has leg sections pushed into the through hole and holds an electronic part on the electric circuit board; and
solder that fixes the holding member to the electric circuit board by filling the through hole into which the leg sections are being pushed, wherein
the holding member includes:
   a base section that has a plate-like shape and is fixed to the electronic part, and
   the leg sections being a pair of leg sections that extend in directions approximately equal to each other and are pushed into the through hole while contacting an inner surface of the through hole at both ends in a longitudinal direction of the through hole, and
   the pair of leg sections have, at respective tip portions, respective slopes that extend in directions approaching each other and facing in opposite directions while being inclined relative to a width direction of the base section, and when the pair of leg sections are pushed into the through hole while contacting the inner surface of the through hole, the respective slopes of the pair of leg sections contact and press each other so that a tip of at least one of the pair of leg sections advances in a slanting direction along the slop, and the tip of at least one of the pair of leg sections passes through the through hole and protrudes in a board thickness direction of the base section beyond the through hole thereby being caught on an edge of the through hole.

Here, the "long through hole" formed in the electric circuit board may be, for example, "a flat through hole" such as "an oval through hole", "an ellipse through hole having a linear part", "a rectangular through hole with rounded corners" and "an egg-shaped through hole", and includes any of them.

The mounting structure of the present invention has the holding member of the present invention. Therefore, like this holding member, the mounting structure has such an advantage that when the holding member is soldered to and thereby mounted on the electric circuit board, in the state of being merely pushed into the through hole and yet to be soldered, the holding member is retained on the electric circuit board by the tip of the leg section caught on the edge of the through hole, which prevents the pair of leg sections from coming out of the through hole, without damaging the surface of the electric circuit board. Furthermore, when the holding member is soldered to and thereby mounted on the electric circuit board, a wobble in the board thickness direction of the base section is suppressed by the tip of the leg section caught on the edge of the through hole. Still furthermore, when the holding member is soldered to and thereby mounted on the electric circuit board, since the pair of leg sections are in contact with the inner surface of the through hole, a wobble in the width direction of the base section also is suppressed. Moreover, when the holding member is soldered to and thereby mounted on the electric circuit board, the through hole is almost filled with the pair of leg sections being pushed in and thus, the molten solder streams along the pair of leg sections and easily rises within the through hole in the solder flow process, and the electric circuit board and the pair of leg sections of the holding member are soldered to each other over a wide area including the through hole. Therefore, the strength of attachment of the electronic part to the electric circuit board is high.

In addition, according to the preset invention, An electronic part that is held on an electric circuit board provided with a long through hole, includes:
a holding member that has leg sections pushed into the through hole and causes the electric circuit board to hold the electronic part, wherein
the holding member includes:
   a base section that has a plate-like shape and is fixed to the electronic part, and
   the leg sections being a pair of leg sections that extend in directions approximately equal to each other and are pushed into the through hole while contacting an inner surface of the through hole at both ends in a longitudinal direction of the through hole, and
   the pair of leg sections have, at respective tip portions, respective slopes that extend in directions approaching each other and facing in opposite directions while being inclined relative to a width direction of the base section, and when the pair of leg sections are pushed into the through hole while contacting the inner surface of the through hole, the respective slopes of the pair of leg sections contact and press each other so that a tip of at least one of the pair of leg sections advances in a slanting direction along the slop, and the tip of at least one of the pair of leg sections passes through the through hole and protrudes in a board thickness direction of the base section beyond the through hole thereby being caught on an edge of the through hole.

Here, the "long through hole" formed in the electric circuit board may be, for example, "a flat through hole" such as "an oval through hole", "an ellipse through hole having a linear part", "a rectangular through hole with rounded corners", "an egg-shaped through hole" and "a rectangular through hole", and includes any of them.

The electronic part of the present invention has the holding member of the present invention. Therefore, like this holding member, the electronic part has such an advantage that in the state of being merely pushed into the through hole and yet to be soldered, the electronic part is retained on the electric circuit board by the tip of the leg section caught on the edge of the through hole, which prevents the pair of leg sections from coming out of the through hole, without damaging the surface of the electric circuit board. Furthermore, a wobble in the board thickness direction of the base section is suppressed by the tip of the leg section caught on the edge of the through hole. Still furthermore, since the pair of leg sections are in contact with the inner surface of the through hole, a wobble in the width direction of the base section also is suppressed. Moreover, the through hole is almost filled with the pair of leg sections being pushed in and thus, the molten solder streams along the pair of leg sections and easily rises within the through hole in the solder flow process. Therefore, the strength of attachment of the electronic part to the electric circuit board after the soldering is high.

According to the present invention, there are provided: the holding member that prevents the leg sections from coming out of the through hole in the state of being merely pushed into the through hole and yet to be soldered, without damaging the surface of the electric circuit board; the mounting structure in which such a holding member is mounted on the electric circuit board; and the electronic part having such a holding member.

### Brief Description of the Drawings

FIG. 1 is an external perspective view illustrating one embodiment of the holding member according to the present invention.
FIG. 2 is a front view and a bottom view illustrating the one embodiment of the holding member according to the present invention.
FIG. 3 is a front view and a bottom view illustrating a process in which the holding member is pushed into a through hole formed in an electric circuit board.
FIG. 4 is a front view and a bottom view illustrating the process in which the holding member is pushed into the through hole formed in the electric circuit board.
FIG. 5 is a front view and a bottom view illustrating the process in which the holding member is pushed into the through hole formed in the electric circuit board.
FIG. 6 is a cross-sectional view illustrating a mounting structure in which the holding member is fixed to an electric circuit board by the solder in a solder flow process.
FIG. 7 is a perspective view illustrating a connector that is one embodiment of an electronic part according to the present invention.
FIG. 8 is a side view and a front view illustrating the connector that is the one embodiment of the electronic part according to the present invention.
FIG. 9 is a diagram illustrating a state in which the connector illustrated in FIG. 7 and FIG. 8 is held on the electric circuit board.

### Best Mode for Carrying out the Invention

Embodiments of the present invention will be described below with reference to the drawings.

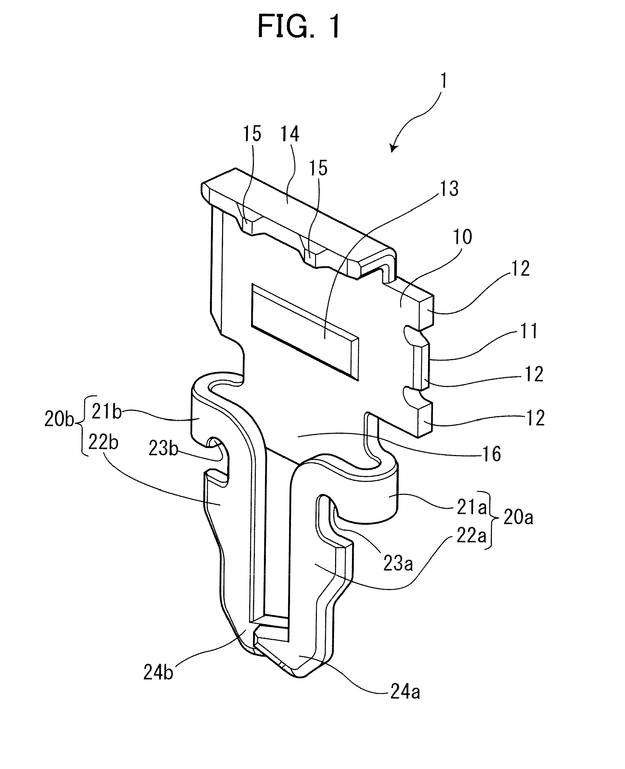

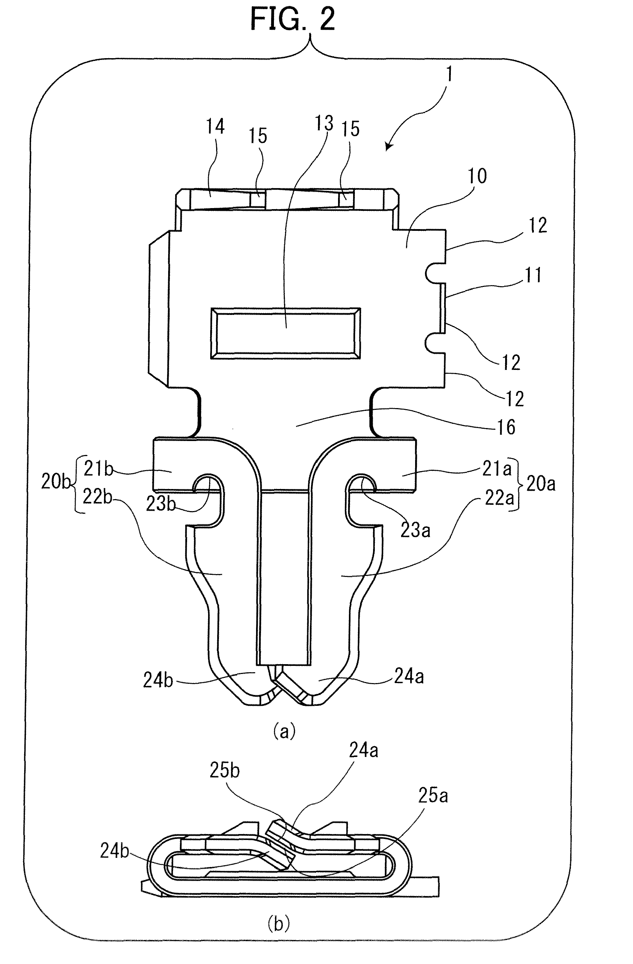

FIG. 1 and FIG. 2 are external views of one embodiment of the holding member according to the present invention. FIG. 1 is a perspective view of a holding member 1 when viewed obliquely from above. FIG. 2 illustrates a plan view in Part (a) and a bottom view in Part (b).

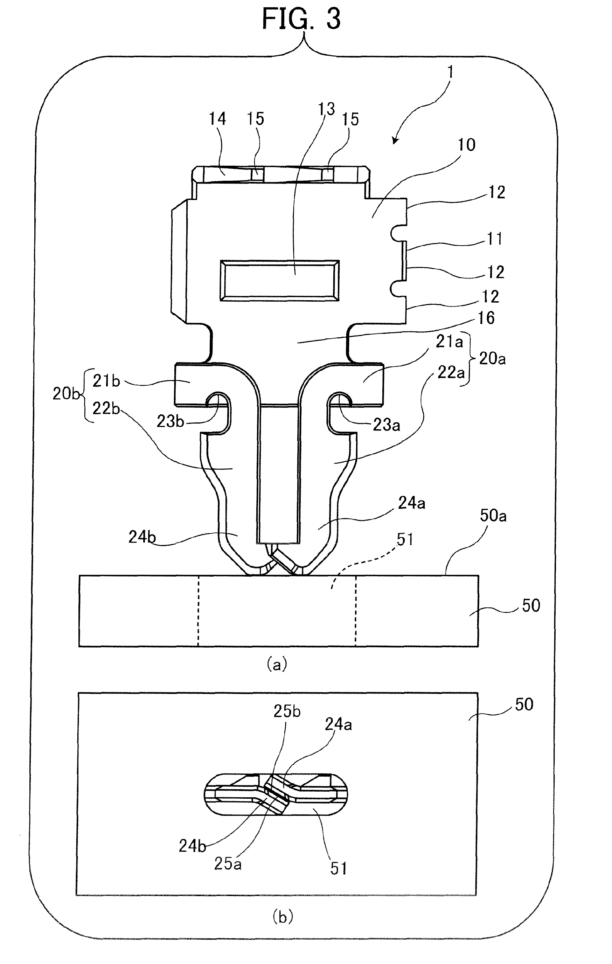

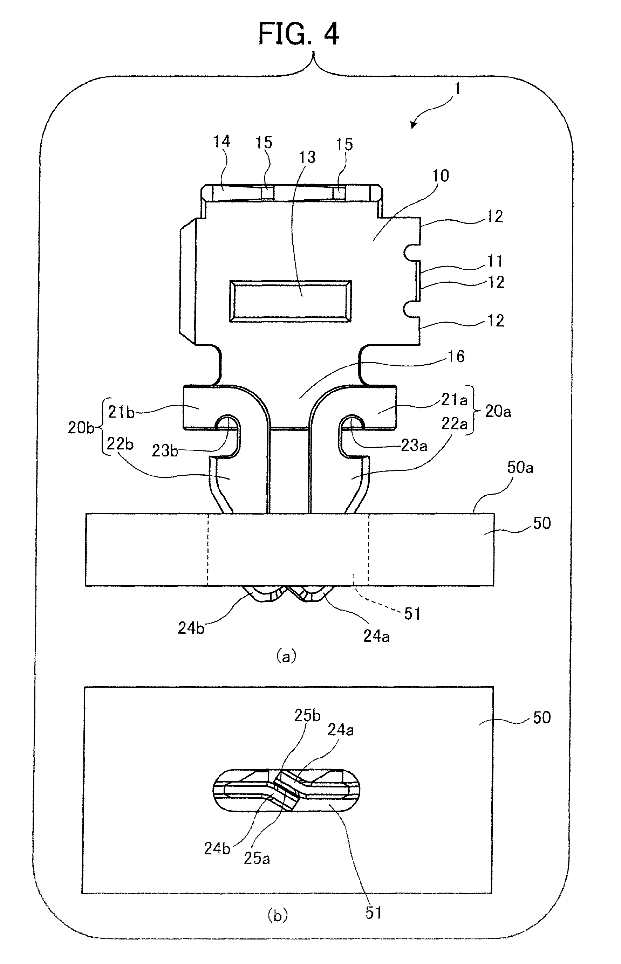

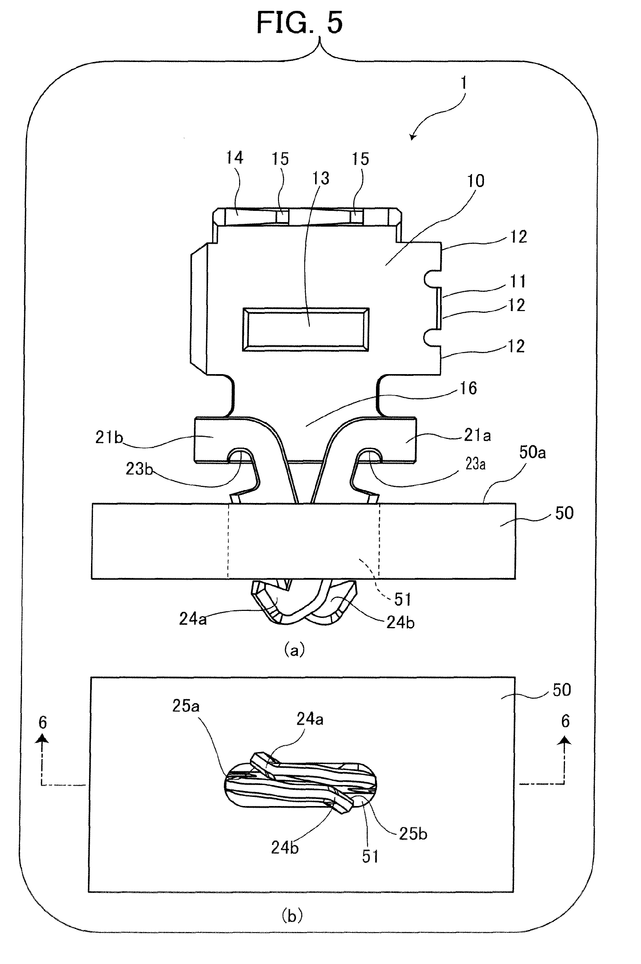

Further, FIG. 3 through FIG. 5 are diagrams that illustrate a process in which the holding member 1 is pushed into a through hole 51 formed in an electric circuit board 50. In FIG. 3 through FIG. 5, Part (a) of FIG. 3, Part (a) of FIG. 4 and Part (a) of FIG. 5 are front views, while Part (b) of FIG. 3 Part (b) of FIG. 4 and Part (b) of FIG. 5 are bottom views.

In the electric circuit board 50, the through hole 51 having a slim (flat) aperture is formed beforehand, and a copper plating layer (not illustrated) is formed on an inner surface of the through hole 51 and a part, which is near the through hole 51, of the electric circuit board 50. The thickness of the electric circuit board 50 is typically 1.2 to 1.6 mm. Incidentally, the through hole 51 is preferably a long hole, and may be "a flat through hole" such as "an oval through hole", "an ellipse through hole having a linear part" and "a rectangular through hole with rounded corners", "an egg-shaped through hole" and "a rectangular through hole."

The holding member 1 holds the electric circuit board 50 by being pushed, from a side where a mounting surface 50a is provided, into the through hole 51 formed in the electric circuit board 50. A board made of copper compound metal such as brass is subjected to stamping, applying of pressure and bending, so that the holding member 1 is formed. Further, the holding member 1 is, for example, plated with tin, thereby having a surface to be wet with molten solder. Incidentally, plating of the holding member 1 is not limited to the tin plating, and may be, for example, solder plating or gold plating. The holding member 1 includes a base section 10 and a pair of leg sections 20 (20a and 20b).

The base section 10 has a protruding section 16 that protrudes downward from one rectangular side. Projections 12 are provided at a side edge 11 of the base section 10. The base section 10 is fixed by being press-fitted into a groove formed on a flank of an insulating housing of a connector. The projections 12 are provided to prevent removal. Further, projections 15 are formed on a bent section 14 provided at an upper end of the base section 10. These projections 15 also are provided to prevent removal like the projections 12, and either the projections 12 or the projections 15 may be used depending on the way of attachment to the insulating housing of the connector. Furthermore, a rib 13 for increasing resistance to bending moment is formed on the base section 10 by pressurizing processing. From the protruding section 16 included in the base section 10 and protruding downward from the one rectangular side, the pair of leg sections 20 (20a and 20b) extend in directions approximately equal to each other.

The pair of leg sections 20 are parts to be pushed into the through hole 51 formed in the electric circuit board 50, while contacting the inner surface of the through hole 51 at both ends in a longitudinal direction. The leg section 20a, which is one of the pair of leg sections 20, is formed by bending a slim plate extending from one end of the protruding section 16. The leg section 20a includes an intermediate section 21a extending from the protruding section 16 and an inserted section 22a extending from the intermediate section 21a continuously. The inserted section 22a is a part to be pushed into the through hole 51. The intermediate section 21a is bent to be shaped like a letter U and further extends in parallel with both the mounting surface 50a (see FIG. 3) of the electric circuit board 50 and the protruding section 16. The inserted section 22a is bent at the approximately right angle to the intermediate section 21a and extends downward. The inserted section 22a is approximately perpendicular to both the protruding section 16 and the mounting surface 50a (see FIG. 3). Further, provided between the intermediate section 21a and the inserted section 22a is a narrow-width section 23a formed to be narrow in width by being partially cut.

The leg section 20b, which is the other of the pair of leg sections 20, extends from the other end of the protruding section 16 and is shaped so that the leg section 20b and the leg section 20a combined are symmetric. In other words, like the leg section 20a, the leg section 20b includes an intermediate section 21b and an inserted section 22b. Also, a narrow-width section 23b is provided between the intermediate section 21b and the inserted section 22b.

Of the pair of leg sections 20 (20a and 20b), the inserted sections 22a and 22b extend in directions approximately equal to each other. Further, formed at the respective tips of the pair of leg sections 20 (20a and 20b) are claws 24a and 24b having slopes 25a and 25b, respectively. These slopes 25a and 25b extend in directions approaching each other and facing in opposite directions while being inclined relative to a width direction of the base section 10 to sit on each other. Therefore, when the pair of leg sections 20 are pushed in while contacting the inner surface of the through hole 51 at both ends in the longitudinal direction, the slopes 25a and 25b contact and press each other while the claws 24a and 24b formed at the respective tips of the pair of leg sections 20 advance along the slopes 25a and 25b in a slanting direction. Subsequently, the claws 24a and 24b pass through the through hole 51 and protrude beyond the through hole 51 in the board thickness direction of the base section 10, thereby being caught on an edge of the through hole 51.

The narrow-width sections 23a and 23b plastically deform in response to distortion produced when the slopes 25a and 25b contact and press each other while advancing in the slanting direction. Thanks to this plastic deformation, engagement of both of the claws 24a and 24b is fixed.

According to the holding member 1 of the present embodiment, in the state in which the holding member 1 is merely pushed into the through hole 51 and yet to be soldered, the claws 24a and 24b formed at the respective tips of the pair of leg sections 20 are caught on the edge of the through hole 51 so that the holding member 1 is retained on the electric circuit board 50, thereby preventing the pair of leg sections 20 from coming out of the through hole 51, without damaging the surface of the electric circuit board 50.

Further, according to the holding member 1 of the present embodiment, in the state in which the holding member 1 is merely pushed into the through hole 51 and yet to be soldered, the claws 24a and 24b formed at the respective tips of the pair of leg sections 20 are reliably caught on the edge of the through hole 51, thanks to the plastic deformation of the narrow-width sections 23a and 23b each formed to have a narrow width by being partially cut. Furthermore, in a process in which the slopes 25a and 25b advance in the slanting direction while contacting and pressing each other and the pair of leg sections 20 are pushed in while contacting the inner surface of the through hole 51 at both ends in the longitudinal direction, a force received by the inner surface from the pair of leg sections 20 is small as compared to a case in which such narrow-width sections 23a and 23b are not provided, and thus, the inner surface is not readily damaged.

The holding member 1 being inserted into the through hole 51 is soldered to the electric circuit board 50 together with terminals of the connector in a solder flow process. According to the holding member 1 of the present embodiment, the through hole 51 is almost filled with the pair of leg sections 20 being pushed in and therefore, molten solder streams along the pair of leg sections 20 and easily rises within the through hole 51 in the solder flow process. Moreover, space in the through hole 51 is filled with the solder and thus, the strength of attachment after the soldering is higher than that of a conventional holding member.

Subsequently, a mounting structure in which the holding member 1 is fixed to the electric circuit board 50 by the solder will be described, together with a step in which the soldering is performed in the solder flow process.

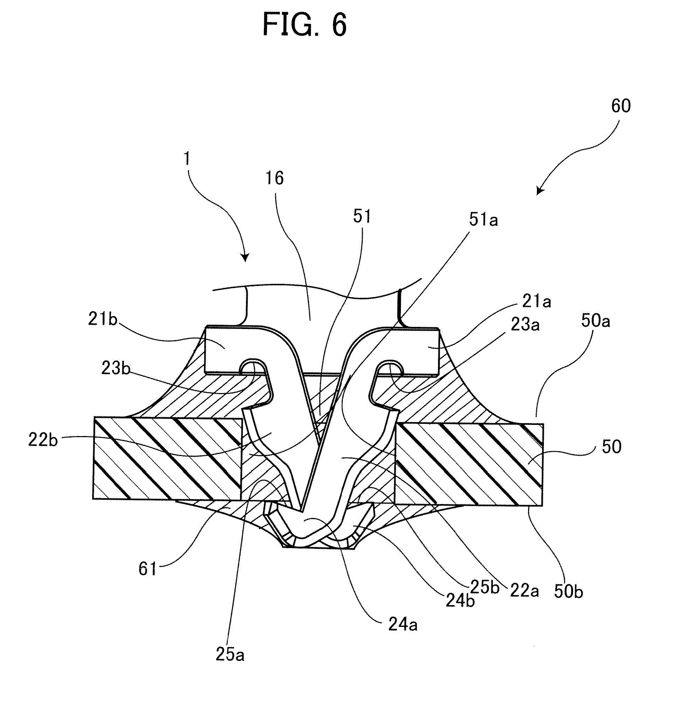

FIG. 6 is a diagram that illustrates a mounting structure 60 in which the holding member 1 described above is fixed to the electric circuit board 50 by the solder, which is a cross-sectional view taken along a line 6-6 illustrated in Part (b) of FIG. 5.

Further, FIG. 6 illustrates the mounting structure 60 in which the holding member 1 is fixed to the electric circuit board 50 by the solder and at the same time depicts a state in which the molten solder adheres to the electric circuit board 50 and the holding member 1 in the solder flow process. Here, both the solder in a molten state in the solder flow process and the solder in a solid state are indicated by the same reference number 61 and will be described.

In the solder flow process, in a state in which the holding member 1 is pushed into the through hole 51, a soldered surface 50b of the electric circuit board 50 is dipped into the molten solder 61. Then, both the copper plating layer (not illustrated) and the holding member 1 become wet with the molten solder 61. The copper plating layer is formed on an inner surface 51a of the through hole 51 and a part, which is near the through hole 51, of the mounting surface 50a. The molten solder 61 streams along the surfaces of the pair of leg sections 20 (20a and 20b) and the inner surface 51a of the through hole 51, and rises within the through hole 51. As mentioned earlier, the through hole 51 is almost filled with the pair of leg sections 20 being pushed in. Therefore, the molten solder 61 is also drawn up due to capillarity. The molten solder 61 drawn up in the through hole 51 soon rises along the surfaces of the pair of leg sections 20 (20a and 20b).

As a result, as illustrated in FIG. 6, the molten solder 61 completely fills the through hole 51 and is further drawn up to go beyond the mounting surface 50a of the electric circuit board 50 from the through hole 51. Afterwards, on the mounting surface 50a of the electric circuit board 50, fillet that spans the pair of leg sections 20 (20a and 20b) and the mounting surface 50a of the electric circuit board 50 is formed.

The mounting structure 60 is formed when the molten solder 61 is cooled and solidified after the solder flow process. On the soldered surface 50b of the electric circuit board 50, fillet that spans the pair of leg sections 20 (20a and 20b) and the soldered surface 50b is formed by the solder 61 and also, the fillet that spans the pair of leg sections 20 (20a and 20b) and the mounting surface 50a is formed on the mounting surface 50a. Incidentally, the mounting structure 60 illustrated in FIG. 6 is equivalent to an example of the mounting structure of the present invention.

According to the mounting structure 60 of the present embodiment, the electric circuit board 50 and the pair of leg sections 20 (20a and 20b) of the holding member 1 are soldered to each other and thus, the holding member 1 is firmly fixed to the electric circuit board 50. In other words, the connector having the holding member 1 is firmly fixed to the electric circuit board 50 by undergoing a soldering process.

Subsequently, the connector held on the electric circuit board by the holding member will be described.

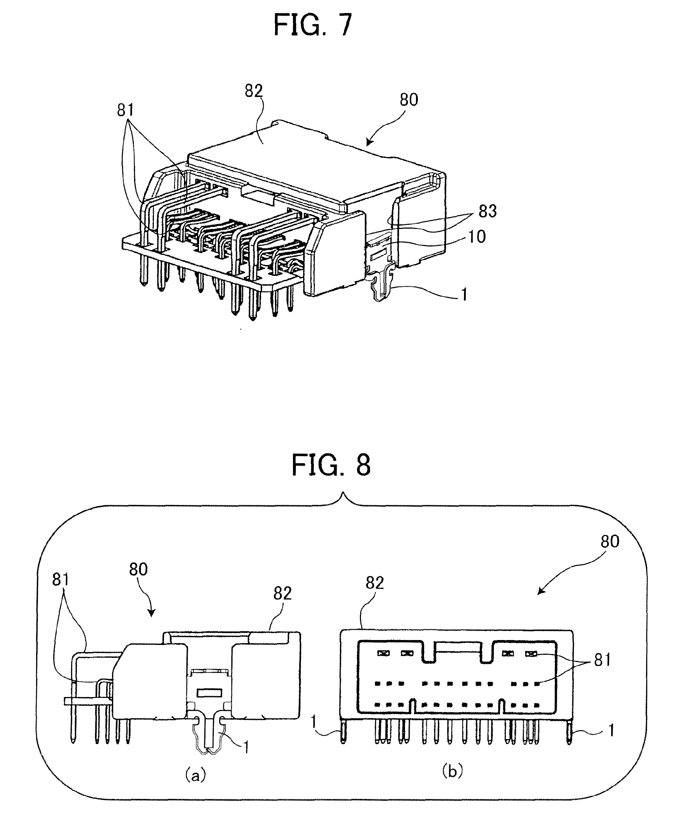

FIG. 7 and FIG. 8 are diagrams which illustrate a connector 80 that is one embodiment of the electronic part according to the present invention. FIG. 7 is a perspective view of the connector 80 when viewed obliquely from behind. Further, FIG. 8 illustrates a side view in Part (a) and a front view in part (b).

The connector 80 is mounted on the electric circuit board built in an electronic device, and electrically connects a circuit on the electric circuit board to another circuit by being mated with another connector (not illustrated) paired with the connector 80.

The connector 80 includes the holding member 1 described above, contacts 81 to be connected with the circuit on the electric circuit board and a housing 82 that secures the holding member 1 and the contacts 81. When the base section 10 of the holding member 1 is press-fitted into a groove 83 formed in the connector 80, the holding member 1 is attached to the connector 80.

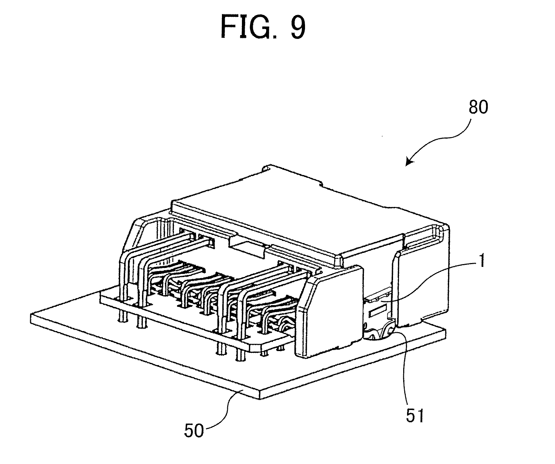

FIG. 9 is a diagram that illustrates a state in which the connector 80 illustrated in FIG. 7 and FIG. 8 is held on the electric circuit board 50.

When the holding member 1 is pushed into the through hole 51, the connector 80 is held on the electric circuit board 50. After the electric circuit board 50 in this state passes the solder flow process, the holding member 1 is soldered to the electric circuit board 50.

According to the connector 80 of the present embodiment, in the state in which the holding member 1 is merely pushed into the through hole 51 and yet to be soldered, the claws 24a and 24b formed at the respective tips of the pair of leg sections 20 are caught on the edge of the through hole 51 so that the connector 80 is held on the electric circuit board 50, without damaging the surface of the electric circuit board 50. In other words, the pair of leg sections 20 are prevented from coming out of the through hole 51.

Incidentally, in the present embodiment, the connector 80 has been described as an example of the electronic part according to the present invention, but the present invention is not limited to this example and is applied to other electronic part held on an electric circuit board by a holding member.

Further, as to the connector 80 of the present embodiment, there has been described the example in which the holding member 1 is attached to the connector 80 and then soldered in the solder flow process. However, the present invention is not limited to this example. For example, as illustrated in FIG. 6, the holding member 1 may be fixed to the connector 80 after the holding member 1 is soldered to the electric circuit board 50.

Furthermore, in the present embodiment, there has been described the example in which the soldering is performed in the solder flow process, but the present invention is not limited to this example. For example, the soldering may be performed in a solder reflow process by filling the through hole with solder paste beforehand or in a soldering process using a soldering iron (so-called hand soldering).

Still further, in the present embodiment, the holding member 1 has been described as being made of brass and plated with tin, but the present invention is not limited to this example. The holding member may be anything as long as the holding member is made of metal and has a surface that becomes wet with molten solder. For example, when the holding member is made of copper compound metal such as the brass like the holding member of the present embodiment, the tin plating may be omitted.

Moreover, in the present embodiment, there has been described the example in which the pair of leg sections are symmetric, and the respective tips of the pair of leg sections protrude in the board thickness direction of the base section beyond the through hole and caught on the edge of the through hole when the pair of leg sections are pushed into the through hole. However, the pair of leg sections of the present invention are not limited to this example. When the pair of leg sections are pushed into the through hole, the tip of only one of the pair of leg sections may protrude in the board thickness direction of the base section beyond the through hole and be caught on the edge of the through hole.

## Claims

1. A holding member that holds an electronic part on an electric circuit board by being pushed into a through hole formed in the electric circuit board, the holding member comprising:
a base section that has a plate-like shape and is fixed to the electronic part; and
a pair of leg sections that extend in directions approximately equal to each other and are pushed into the through hole while contacting an inner surface of the through hole,
wherein the pair of leg sections have, at respective tip portions, respective slopes that extend in directions approaching each other and facing in opposite directions while being inclined relative to a width direction of the base section, and when the pair of leg sections are pushed into the through hole while contacting the inner surface of the through hole, the respective slopes of the pair of leg sections contact and press each other so that a tip of at least one of the pair of leg sections advances in a slanting direction along the slop, and the tip of at least one of the pair of leg sections passes through the through hole and protrudes in a board thickness direction of the base section beyond the through hole so as to be caught on an edge of the through hole.

2. The holding member according to claim 1, wherein the pair of leg sections are symmetric, and when being pushed into the through hole, the respective tips of the pair of leg sections protrude in the board thickness direction of the base section beyond the through hole so as to be caught on the edge of the through hole.

3. The holding member according to claim 2, wherein the pair of leg sections have, at parts close to the base section, respective narrow-width sections that are formed to be narrow in width by being partially cut and plastically deform in response to distortion produced when the slopes advance in a slanting direction while contacting and pressing each other.

4. The holding member according to claim 1, wherein when the pair of leg sections are pushed into the through hole, the tip of only one of the pair of leg sections protrudes in the board thickness direction of the base section beyond the through hole thereby being caught on the edge of the through hole, and
the one of the pair of leg sections has, at a part closer to the base section, a narrow-width section that is formed to be narrow in width by being partially cut and plastically deforms in response to distortion produced when the slopes advance in a slanting direction while contacting and pressing each other.

5. The holding member according to any of claim 1, wherein the holding member is made of metal and has a surface to be wet with molten solder.

6. A mounting structure comprising:
an electric circuit board that has a long through hole;
a holding member that has leg sections pushed into the through hole and holds an electronic part on the electric circuit board; and
solder that fixes the holding member to the electric circuit board by filling the through hole into which the leg sections are being pushed, wherein
the holding member includes:
a base section that has a plate-like shape and is fixed to the electronic part, and
the leg sections being a pair of leg sections that extend in directions approximately equal to each other and are pushed into the through hole while contacting an inner surface of the through hole at both ends in a longitudinal direction of the through hole, and
the pair of leg sections have, at respective tip portions, respective slopes that extend in directions approaching each other and facing in opposite directions while being inclined relative to a width direction of the base section, and when the pair of leg sections are pushed into the through hole while contacting the inner surface of the through hole, the respective slopes of the pair of leg sections contact and press each other so that a tip of at least one of the pair of leg sections advances in a slanting direction along the slop, and the tip of at least one of the pair of leg sections passes through the through hole and protrudes in a board thickness direction of the base section beyond the through hole thereby being caught on an edge of the through hole.

7. An electronic part that is held on an electric circuit board provided with a long through hole, the electronic part comprising:
a holding member that has leg sections pushed into the through hole and causes the electric circuit board to hold the electronic part, wherein
the holding member includes:
a base section that has a plate-like shape and is fixed to the electronic part, and
the leg sections being a pair of leg sections that extend in directions approximately equal to each other and are pushed into the through hole while contacting an inner surface of the through hole at both ends in a longitudinal direction of the through hole, and
the pair of leg sections have, at respective tip portions, respective slopes that extend in directions approaching each other and facing in opposite directions while being inclined relative to a width direction of the base section, and when the pair of leg sections are pushed into the through hole while contacting the inner surface of the through hole, the respective slopes of the pair of leg sections contact and press each other so that a tip of at least one of the pair of leg sections advances in a slanting direction along the slop, and the tip of at least one of the pair of leg sections passes through the through hole and protrudes in a board thickness direction of the base section beyond the through hole thereby being caught on an edge of the through hole.
